# EUROPEAN PATENT APPLICATION

(11) **EP 1 128 419 A2**
(43) Date of publication of application: **29.08.2001**
(21) Application number: 01301740.5
(22) Date of filing: 26.02.2001
(51) Int. Cl.: H01L 21/306, C22B 9/05, C22B 9/10

(54) **Method of cleaning a silicon, carbon, germanium, tin or lead surface**

(30) Priority: 25.02.2000 JP 2000050265
(71) Applicant: Japan as Represented by Director General of Ministry of Education, Culture, Sports, Science and Technology N.R.I. for Metals, Tsukuba-shi, Ibaraki (JP)
(72) Inventor: Higai, Shinichi, Tsukuba-shi, Ibaraki (JP); Oono, Takahisa, Tsukuba-shi, Ibaraki (JP)
(74) Representative: Campbell, Neil Boyd

(57) **Abstract**

Metal impurities under the surface of a group IV element are removed to purify and flatten the surface. Such a method for purifying an Si, C, Ge, Sn or Pb surface having metal impurities under said surface comprises (I) hydrogenating the surface in the gas phase or liquid phase to thereby extracting the metal impurities onto the surface; and (II) removing the metal impurities.

## Description

This invention concerns a method for purifying a silicon, carbon, germanium, tin or lead surface and a method for flattening such a surface at the atomic level. More particularly, it relates to a method for purifying an Si surface by removing metal impurities present under the Si surface which cannot be removed by existing purification strategies such as annealing. By removing such metal impurities and hence surface defects, it has also been surprisingly found that the surface, at an atomic level, is flattened.

Along with improvements in integration and fine processing in semiconductor LSI, there is a need to reduce the roughness of the surface of an Si substrate at an atomic level.

Current methods for improving the smoothness of an Si surface at the atomic level including a method in which the surface is heated in a super-high vacuum. However, this method, which has been known for a long time, is costly and it has also proved difficult to maintain the smoothness of the surface during device manufacture since the obtained surface is readily oxidized. Moreover, it has been found that heating under a high vacuum gives rise to undesired effects on end device characteristics. In view of this, the method is considered unsuitable for industrial processes.

The surface of Si plane orientation (001) is expected to be the smoothest. However, the presence of surface defects called Dimer Vacancies (hereinafter referred to as DV defects) in the (001) plane are a significant smoothness problem. The occurrence of the DV defects is considered to be attributable to the presence of metal impurities, particularly, the transition metal Ni under the Si surface near the DV defect and, accordingly, it is proposed that the Si surface can be flattened at the atomic level by removing such metal impurities.

The contamination of an Si surface by metal impurities can occur at various stages during processes for manufacturing Si wafer or Si-LSI (large scale integration).

The contamination of an Si surface has a negative influence upon the properties of a device and may decrease the reliability thereof. By removing the metal impurities, it is believed that a stable and reliable device will result.

It has been surprisingly found that metal impurities under a surface can be readily extracted using a gas or liquid phase hydrogenation thereby rendering the surface not only purified but also smoother at the atomic level.

Thus, viewed from one aspect the invention provides a method for purifying an Si, C, Ge, Sn or Pb surface having metal impurities under said surface said method comprising (I) hydrogenating the surface in the gas phase or liquid phase to thereby extracting the metal impurities onto the surface; and (II) removing the metal impurities.

Viewed from another aspect the invention provides a method of flattening an Si, C, Ge, Sn or Pb surface having metal impurities under said surface said method comprising (I) hydrogenating the surface in the gas phase or liquid phase to thereby extracting the metal impurities onto the surface; and (II) removing the metal impurities.

Preferably the surface is an Si surface. In a further preferred embodiment, the metal impurities are preferable transition metals, especially Ni or Ti.

In a further preferred embodiment the Si surface has plane orientation (001).

Viewed from a further aspect the invention also provides a method of manufacturing Si wafer or Si-LSI in which the method for purifying the Si surface or method for flattening the Si surface is incorporated as a step of the process.

Fig. 1 shows a view illustrating the energy difference (eV) between the most stable site on an Si (001) surface and the most stable site for an Ni atom under the Si surface;

Fig. 2 shows a view illustrating the energy difference between the most stable site on an Si (001) surface and the most stable site for a Ti atom under the Si surface;

Fig. 3 shows a view illustrating the energy difference between the most stable site on a hydrogenated Si (001) - (2x1) surface and the most stable site for an Ni atom under such a surface;

Fig. 4 shows a view illustrating the energy difference between the most stable site on a hydrogenated Si (001) - (2x1) surface and the most stable site for a Ti atom under such a surface;

Fig. 5 shows a view illustrating the differences in charge density when an Ni atom is in a stable site in the second or third Si layer for a clean Si (001) layer and a hydrogenated Si (001) - (2x1) surface. A solid line represents an increased region and a broken line represents a decreased region of charge density respectively.

Fig. 6 shows a theoretical view illustrating the effect of the present invention.

In this invention, when an Si surface containing metal impurities under the surface is hydrogenated, metal impurities are extracted onto the Si surface, and the Si surface is hence purified by removing the metal impurities. Further, since the metal impurities are removed, surface defects are eliminated and the Si surface is rendered smooth at the atomic level.

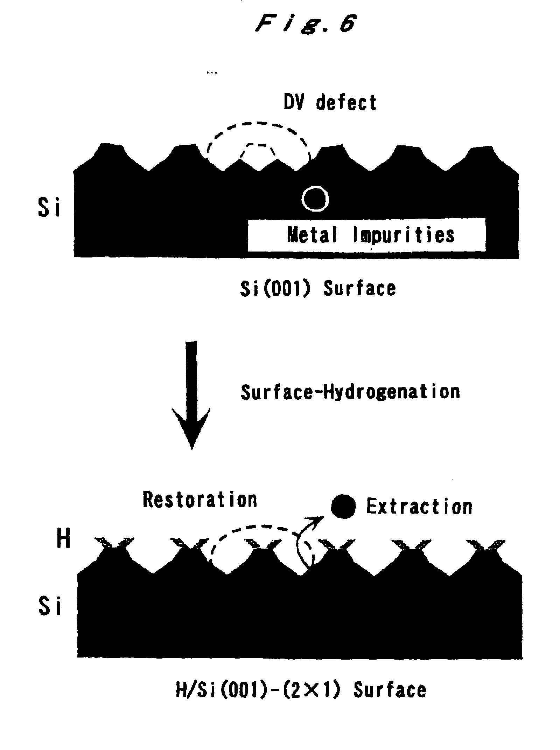

Fig. 6 shows a theoretical view illustrating the effect of the present invention, in which the Si (001) surface is hydrogenated and metal impurity extracted and removed from the surface. Hence, on the H/Si (001)-(2x1) surface, the DV defect on the Si (001) surface is eliminated.

Hence, by the methods of the invention, an Si surface is purified and is atomically flattened.

Hydrogenation of the Si surface is conducted by conventional gas phase or liquid phase methods. To attain an extra smooth Si surface, use of a gas phase method is preferred since this method in believed to result in less damage to the Si surface. Hydrogenation is preferably carried out at a temperature below 400°C, e.g. ambient temperature (25°C) to 400°C.

All metal impurities found under an Si surface can be removed by this invention. When the metal impurities are transition metals, especially Ni or Ti, a remarkable reduction of the number of surface defects can be achieved and the Si surface is simultaneously flattened at an atomic level.

Further, the surface to be purified/flattened may be of any plane orientation but preferably flattening of the Si surface is attained when Si has plane orientation (001).

Further, the method of purifying the Si surface or the method of atomically flattening the Si surface according to this invention can be introduced into a process for the manufacture of Si wafer or Si-LSI.

Extracted metal impurities on the Si surface are removed by a variety of methods, such as a gettering method.

Extraction of the metal impurities onto the Si surface by hydrogenation of the Si surface occurs, through the lone pairs (dangling orbit) present on the surface which bind hydrogen atoms.

The group IV elements C (carbon), Ge, Sn and Pb, have similar surface-structure to an Si surface due to the presence of lone pairs and the potential for similar orbital interactions. Hence, surface flattening and purification by the method of the invention can also be achieved in C, Ge, Sn or Pb surfaces.

This invention is based on first-principles theoretical calculations. The first-principles calculations are based on density functional formalism with the generalized gradient approximation. Significantly the calculations do not use empirical parameters. For the atomic potential, pseudo-potential is adopted. The plane wave function is also adopted as the basis function. The plane wave basis set up to the cut-off energy off 20.25 Ry. The partial core correction is employed for Ni and Ti.

On this calculation, the lattice constants of Si, Ni and Ti are +0.5%, +1.2% and +1.3% respectively, and the bulk moduli of Si, Ni and Ti are -5.6%, +1.3% and +6.7%. Calculated Si-H surface bond length, is accurate to +0.3% compared to the bond length of Si-H in SiH₄.

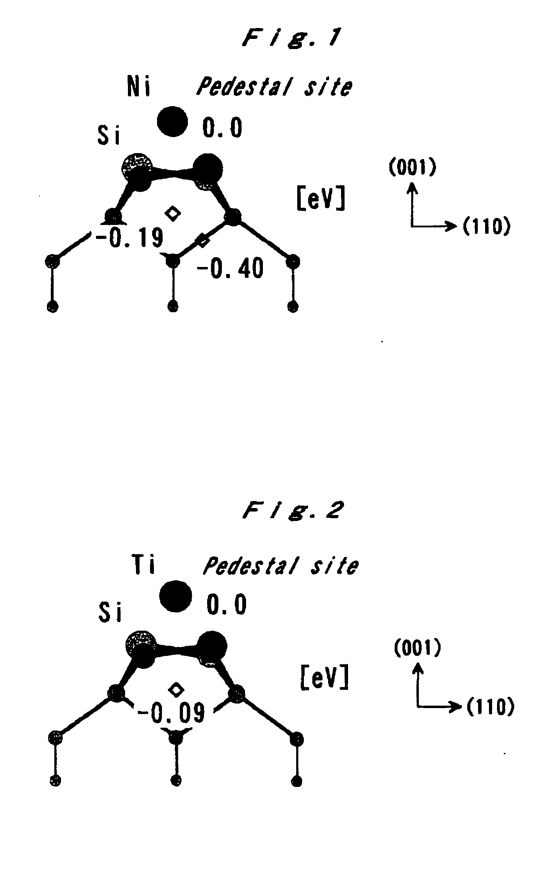

Fig. 1 and Fig. 2 show the energy difference between the most stable site on a clean Si (001) surface and a stable site under the Si surface containing a Ti atom or Ni atom. For such transition metals the most stable site on the Si surface is a pedestal site on the dimer row. However, this site is not as stable as the most stable site under the Si surface.

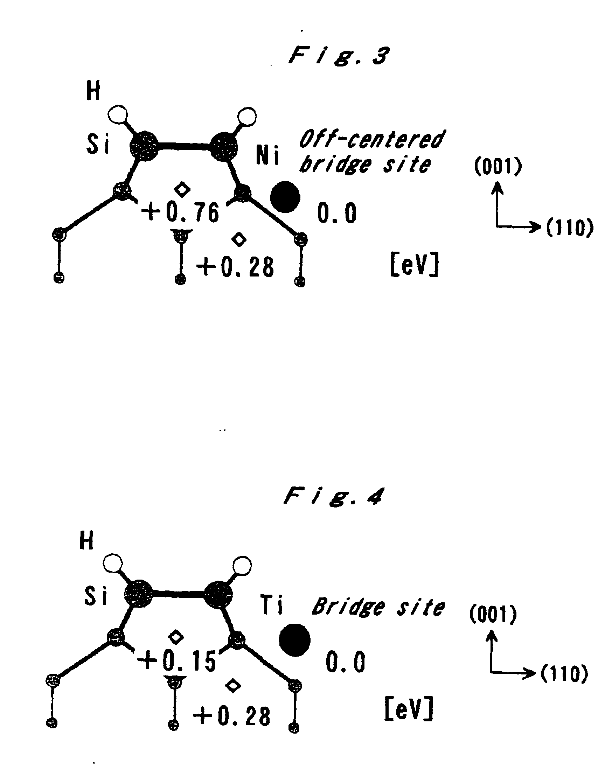

Fig. 3 and Fig. 4 show the energy difference between the most stable site for an Ni or Ti atom on a hydrogenated Si (001) - (2x1) surface and the most stable site under the Si surface. By hydrogenating the Si (001) surface, the most stable site on the surface moves from the pedestal site into an off-centered bridge site between dimer rows for Ni atoms, or a bridge site for Ti atoms. Further, the stable site under the Si surface which was more stable than the most stable site on the surface for a clean Si (001) surface becomes instable to atoms such as Ti or Ni atoms.

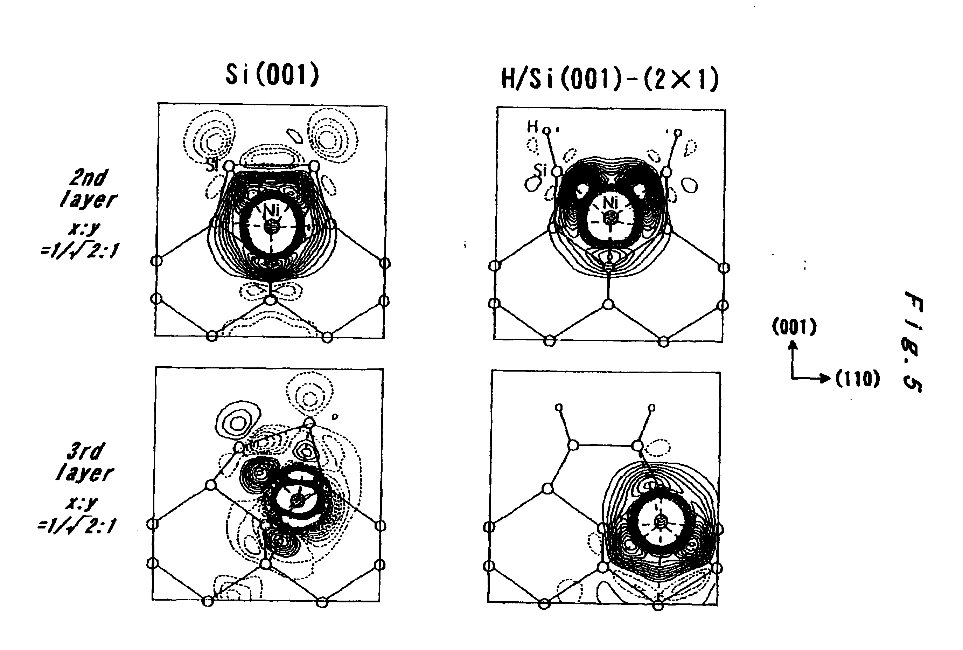

The mechanism of the phenomenon described above is described below. Fig. 5 shows the different charge densities for an Ni atom on the stable site of second and third Si layers. The values are obtained by subtracting the difference in charge density for the lone Ni atom and underlying portion from the total charge density ([total charge density) - (charge density of lone Ni atom] - [difference charge density of underlying charge density]). That is, Fig. 5 shows the state of circumstance charge transfer by the presence of Ni atom inside Si. The charge density increases greatly in the Ni-Si bonding region in any of the clean Si (001) surfaces and the hydrogenated Si (001) - (2x1) surfaces. For compensating the bonding charge of Ni-Si, charge density in the dangling orbit (lone pair) and the Si-Si bonded portion of the dimer Si atoms is decreased on the clean Si (001) surface. On the other hand, on the hydrogenated Si (001) - (2x1) surface, since the lone pair is bound to hydrogen (II), the charge density is decreased only at the Si-Si bond portion. That is, it is considered that the absence or presence of lone pair reflects the stability of the Ni atom inside Si.

Utilising the mechanisms explained above, it is possible to extract transition metal impurities from under an Si surface onto the surface by hydrogenating the Si surface. Hence, Ni can be extracted onto the Si surface by hydrogenating the Si surface, e.g. by exposing said surface to hydrogen gas or hydrogen radicals, thereby purifying and atomically flattening the Si surface.

In the preceding discussions, Ni and Ti are mentioned is examples of metal impurities, but it would be apparent that to the person skilled in the art that other transition metals, as well as non-transition metal impurities can be removed by this invention.

Further, whilst the Si surface having plane orientation (001) is shown as an example in the foregoing explanation metal impurities under the Si surface can be removed from other plane orientations. The presence of the lone pair on the surface is attributable to the stable presence of metal impurities inside Si as described above, and the lone pair always remains on the clean Si surface although methods are available for eliminating unstable lone pairs.

Furthermore, as described above, along with removal of metal impurities since the number of surface defects are decreased, flattening of the Si surface at an atomic level can be achieved.

Hydrogen-annealing is known as an effective method for alleviating problems associated with metal impurity contamination on the surface of Si wafer. However, this known method differs from the method of present invention as follows;
1) Hydrogen atoms are eliminated from a hydrogenated Si surface at temperatures of from about 400°C to 600°C. The hydrogen-annealing method is carried at higher temperatures of from about 900°C to 1200°C. At such temperatures hydrogen atoms cannot bind the Si lone pair.
2) The present invention eliminates surface defects on a single atom level. Conversely hydrogen-annealing eliminates surface defects only on a *µ*m level.

As has been described above specifically, purification of an Si surface by the removal of metal impurities found under the Si surface and corresponding flattening of the Si surface by reduction of surface defects can be achieved in accordance with this invention. The time and cost of manufacturing such highly pure and flat Si surfaces can be remarkably reduced. Moreover, the method of this invention can also contribute to the manufacture of improved Si wafer or Si-LSI, at a reduced cost.

## Claims

1. A method for purifying an Si, C, Ge, Sn or Pb surface having metal impurities under said surface said method comprising (I) hydrogenating the surface in the gas phase or liquid phase to thereby extracting the metal impurities onto the surface; and (II) removing the metal impurities.

2. A method of flattening an Si, C, Ge, Sn or Pb surface having metal impurities under said surface said method comprising (I) hydrogenating the surface in the gas phase or liquid phase to thereby extracting the metal impurities onto the surface; and (II) removing the metal impurities.

3. A method as claimed in claim 1 or 2, wherein the surface is an Si surface.

4. A method as claimed in claim 1 to 3, wherein the surface has plane orientation (001).

5. A method as claimed in any one of claims 1 to 4, wherein the metal impurities are transition metals.

6. A method as claimed in claim 5, wherein the metal impurity is Ni or Ti.

7. A method of manufacturing Si wafer or Si-LSI comprising a method as claimed in any one of claims 1 to 6.
